# EUROPÄISCHE PATENTSCHRIFT

(11) **EP 2 179 438 B1**
(45) Veröffentlichungstag und Bekanntmachung des Hinweises auf die Patenterteilung: **25.09.2019**
(21) Anmeldenummer: 08784599.6
(22) Anmeldetag: 02.07.2008
(51) Int. Cl.: B65G 49/06, H01L 21/67, H01L 21/677, H05K 13/00

(54) **HALTEMITTEL, TRANSPORTVORRICHTUNG MIT HALTEMITTELN, UND VERFAHREN ZUM TRANSPORT VON DÜNNEN FLÄCHIGEN SUBSTRATEN, INSBESONDERE LEITERPLATTEN, MIT EINER TRANSPORTVORRICHTUNG**
HOLDING MEANS, TRANSPORTING DEVICE WITH HOLDING MEANS, AND METHOD FOR TRANSPORTING THIN PLANAR SUBSTRATES, IN PARTICULAR PRINTED CIRCUIT BOARDS, WITH A TRANSPORTING DEVICE
MOYENS DE MAINTIEN, DISPOSITIF DE TRANSPORT AVEC DES MOYENS DE MAINTIEN, ET PROCÉDÉ POUR LE TRANSPORT DE SUBSTRATS MINCES ÉTENDUS, EN PARTICULIER DE CIRCUITS IMPRIMÉS, AVEC UN DISPOSITIF DE TRANSPORT

(30) Priorität: 30.07.2007 DE 102007038116
(43) Veröffentlichungstag der Anmeldung: 28.04.2010
(73) Patentinhaber: Gebr. Schmid GmbH, 72250 Freudenstadt (DE)
(72) Erfinder: NICOLET, Laurent, CH-1510 Moudon (CH)
(74) Vertreter: Patentanwälte Ruff, Wilhelm, Beier, Dauster & Partner mbB
(86) Internationale Anmeldenummer: PCT/EP2008/005395
(87) Internationale Veröffentlichungsnummer: WO 2009/015742

(56) Entgegenhaltungen:
- DE-A1- 4 337 811
- DE-A1- 10 131 945
- DE-A1- 10 154 884
- DE-A1- 19 522 733
- JP-A- 2002 299 406
- JP-A- 2006 248 651

## Beschreibung

Die Erfindung betrifft Haltemittel zum Haltern bzw. zum Transport von dünnen flächigen Substraten, insbesondere Leiterplatten, die unter Umständen sehr dünn sind, nach dem Oberbegriff des Anspruchs 1. Ebenso betrifft die Erfindung eine Transportvorrichtung mit solchen Haltemitteln und ein Verfahren zum Transport derartiger Substrate mit einer derartigen Transportvorrichtung.

Bei der Bearbeitung von dünnen flächigen Substraten wie beispielsweise Leiterplatten in der Leiterplattenindustrie, insbesondere bei chemischen Ätzverfahren, findet eine Behandlung oftmals in einer nasschemischen Prozesslinie statt. Dabei ist es bekannt, die Leiterplatten auf Rollen oder Walzenbahnen aufzulegen und durch eine Behandlungseinrichtung zu transportieren. Mit zunehmend dünner werdenden Substraten, insbesondere Leiterplatten, die schon folienartig sind, wird dies jedoch immer schwieriger. Die Substrate weisen nicht genügend Eigenstabilität auf oder können aufgrund des sehr geringen Gewichts durch Besprühen mit Ätzflüssigkeit odgl. bewegt oder verschoben werden. Des Weiteren sind die Oberflächen mancher Substrate derart empfindlich, dass sie bereits durch das Aufliegen auf den Rollen beschädigt werden könnten.

Die DE 101 31 945 A1 beschreibt Haltemittel sowie eine Transportvorrichtung, um Leiterplatten zu transportieren zum gemeinsamen Bearbeiten. Dabei werden jeweils zwei Leiterplatten mittels Haltemitteln verbunden. Diese Haltemittel sind entweder mehrere einzelne Klammern, die zwei benachbarte Leiterplatten miteinander verbinden, oder Klebstofftropfen. Dabei liegen die Leiterplatten zum Transport auf durchgehenden Transportriemen direkt auf.

Die JP 2006 248651 A1 beschreibt Haltemittel für eine Transportvorrichtung zum Transport von dünnen flächigen Substraten, wobei diese Haltemittel jeweils einzeln für sich an jeder Ecke eines Substrates angreifen.

Dazu weist jedes Haltemittel eine einzelne Klammer auf, die eine Ecke des Substrates greift. Die Haltemittel stehen seitlich von den Substraten ab und laufen zu einer außerhalb der Transportbahn der Substrate verlaufenden Schiene. Damit werden jeweils einzelne Substrate transportiert und dabei unter Spannung gehalten.

Die DE 195 22 733 A1 beschreibt ein Verfahren und eine Transportvorrichtung zum Transport dünner flächiger Gegenstände, wie beispielsweise Leiterplatten. Mittels draht- oder schnurähnlicher Verbindungsmittel werden Leiterplatten zu einer Art durchgehenden Kette miteinander verbunden und dann auf übliche Art und Weise transportiert. Durch die Verbindungsmittel wird ihr Abstand während des Transportierens und Behandelns eingestellt und gehalten.

Die DE 43 37 811 A1 beschreibt eine Möglichkeit, Leiterplatten zu transportieren. Dabei werden die Leiterplatten an einem Rand mit Klemmvorrichtungen ergriffen und festgehalten, die an einer umlaufenden Transportkette vorgesehen sind. Die Klemmvorrichtungen greifen nur an einer Seite der Leiterplatten am Rand an, so dass die Leiterplatten leicht in einer Richtung quer dazu und weg von der Transportkette entnommen werden können. Die DE 43 37 811 A1 beschreibt ebenfalls eine Transportvorrichtung aus zwei parallelen Kettenschleifen zum Transport von mehreren Leiterplatten gleichzeitig nebeneinander. Zwischen diesen Kettenschleifen werden von Kettengliedern Tragstreifen gehalten. Diese Tragstreifen sind mit nach oben vorstehenden Stiften versehen. Die Leiterplatten sind in einem Bereich inaktiver Streifen mit den Stiften zugeordneten Löchern versehen. Außerdem sind die Tragstreifen in Transportrichtung der Leiterplatten in einem solchen Abstand voneinander angeordnet, dass die den inaktiven Streifen gegenüberliegenden Leiterplattenkanten der Leiterplatten auf benachbarten Tragstreifen aufliegen können. Wenn mehrere Leiterplatten nebeneinander auf die Stifte gelegt werden, sind die Leiterplatten gegen ein Verrutschen gesichert, und liegen die Leiterplatten auf ihren inaktiven Streifen und ihren den inaktiven Streifen gegenüberliegenden Leiterplattenkanten auf den benachbarten Tragstreifen auf.

Die JP 2002 299406 A beschreibt ein Haltemittel für dünne Substrate, mit denen diese gehalten und transportiert werden können. Dabei wird ein Substrat zwischen zwei umlaufenden Rahmen gelegt und diese durch integrierte Haltemagnete zueinander hin gezogen. So können sie das Substrat fest zwischen sich halten.

Der Erfindung liegt die Aufgabe zugrunde, eingangs genannte Haltemittel, eine eingangs genannte Transportvorrichtung sowie ein eingangs genanntes Verfahren zu schaffen, mit denen Probleme des Standes der Technik vermieden werden können und insbesondere ein guter und sicherer Transport von flächigen Substraten möglich ist, vor allem dann, wenn diese dünn bzw. mechanisch empfindlich sind.

Gelöst wird diese Aufgabe durch Haltemittel mit den Merkmalen des Anspruchs 1, eine Transportvorrichtung mit den Merkmalen des Anspruchs 11 sowie ein Verfahren mit den Merkmalen des Anspruchs 12. Vorteilhafte sowie bevorzugte Ausgestaltungen der Erfindung sind Gegenstand der weiteren Ansprüche und werden im Folgenden näher erläutert. Dabei werden manche Merkmale entweder nur für die Transportvorrichtung oder nur für das Verfahren beschrieben. Sie sollen jedoch unabhängig voneinander sowohl für die Transportvorrichtung als auch für das Verfahren gelten können.

Der Wortlaut der Ansprüche wird durch ausdrückliche Bezugnahme zum Inhalt der Beschreibung gemacht.

Erfindungsgemäß ist vorgesehen, dass Haltemittel vorgesehen sind und die Transportvorrichtung Haltemittel aufweist für eine feste, insbesondere auch formschlüssige, Verbindung mit einem Substrat. Die erfindungsgemäßen Haltemittel stehen dabei nach Art von Haltebügeln an beiden Seiten der Substrate quer zur Transportrichtung über deren Breite über, sind also an beiden Seiten breiter als die Substrate. Des Weiteren sind erfindungsgemäße Haltemittel dazu ausgebildet, mit einer Transporteinrichtung zusammenzuwirken zum Transport der Substrate durch eine Behandlungseinrichtung. Damit ist es beispielsweise möglich, die Substrate nur an einem oder auch mehreren dieser Haltemittel zu befestigen oder aufzuhängen bzw. zu haltern, sodass auf die genannten Rollenbahnen verzichtet werden kann. Die Substrate können im wesentlichen frei in der Luft liegen und nur von den Haltemitteln gehalten werden. Die erfindungsgemäßen Haltemittel bzw. die erfindungsgemäße Transportvorrichtung sind bzw. ist vorteilhaft dazu ausgebildet, die Substrate in einer Transportrichtung mit einer Transportebene zu bewegen, welche der Substratsebene entspricht. Die Haltemittel können beispielsweise flach bzw. bügelartig ausgebildet sein.

Für eine möglichst gute Befestigung bzw. Halterung der Substrate ist vorgesehen, dass die Haltemittel an beiden Seiten über die Substrate überstehen. Dadurch ist es möglich, zum einen die Substrate über ihre Breite zu haltern bzw. zu befestigen und sie sozusagen auch etwas zu spannen. Des Weiteren kann durch beidseitig überstehende Haltemittel eine beidseitige Befestigung an der Transporteinrichtung erfolgen, die sehr gut ist.

In Ausgestaltung der Erfindung ist vorgesehen, dass derartige Haltemittel sowohl am in Transportrichtung vorne liegenden als auch am in Transportrichtung hinten liegenden Ende der Substrate vorgesehen sind. Dadurch kann nicht nur eine gesamte Halterung der Substrate erfolgen, sondern es ist auch ein Spannen der Substrate in Längsrichtung bzw. in Transportrichtung möglich. Dabei ist jedoch zu beachten, dass sich eine derartige Anordnung deutlich unterscheidet von einem Einspannen eines Substrats in einem ganzen umlaufenden Rahmen, der eventuell selbsttragend ist. Die Stabilität der Anordnung bzw. der Halterung der Substrate erfolgt bei der Erfindung vorteilhaft dadurch, dass die Haltemittel wiederum stabil mit der Transporteinrichtung verbunden sind bzw. zusammenwirken. So können auch die Haltemittel einfacher ausgebildet sein.

Erfindungsgemäß weisen die Haltemittel mindestens zweiteilige Haltebügel auf mit einem unteren Halteteil und einem oberen Halteteil. Zwischen diesen beiden Halteteilen wird das Substrat befestigt, wozu die Halteteile speziell ausgebildet sind. Hierfür gibt es mehrere Möglichkeiten, von denen einige im Folgenden beispielhaft genannt werden. Dabei kann vorgesehen sein, dass die Haltemittel für eine formschlüssige Verbindung mit dem Substrat bzw., bei mehrteiligen Haltemitteln, miteinander ausgebildet sind. So kann beispielsweise ein Vorsprung am Haltemittel formschlüssig in eine Ausnehmung oder Öffnung in dem Substrat eingreifen. Vorteilhaft sind dabei mehrere derartige Vorsprünge vorgesehen, wobei die Substrate dabei bevorzugt gegen das Haltemittel gedrückt bzw. gehalten sind, damit die Vorsprünge nicht aus dem Substrat herausrutschen. Es kann beispielsweise vorgesehen sein, dass die Haltemittel zweiteilig sind bzw. zwei Halteteile aufweisen, die das Substrat zwischen sich einklemmen. Vorbeschriebene Vorsprünge können nur an einem einzigen Halteteil vorgesehen sein, beispielsweise an dem unteren Halteteil. Die Vorsprünge können beispielsweise stiftartig sein, insbesondere im oberen Bereich leicht angespitzt für ein leichteres Einführen in eine entsprechende Ausnehmung. Die Vorsprünge an einem Halteteil können dabei durch das Substrat hindurchgreifen und auf der anderen Seite derart weit überstehen, dass sie auch in entsprechende Ausnehmungen in dem anderen Halteteil eingreifen und so die beiden Halteteile formschlüssig verbunden werden, zumindest gegen Bewegungen in der Transportebene. Dabei ist vorteilhaft vorgesehen, dass sich die Vorsprünge quer zur Transportebene erstrecken.

Besteht ein Haltemittel allgemein aus zwei oder eventuell sogar noch mehr Halteteilen, so sollten diese beim Durchlauf des Substrats durch die Behandlungseinrichtung zusammengehalten werden, zumindest gegen Bewegungen in der Transportebene bzw. der Substratebene.

Um ein Haltemittel mit mehreren Halteteilen zusammenzuhalten, gibt es mehrere Möglichkeiten. Eine davon kann ein Formschluss sein, insbesondere auch in Richtung quer zur Substratebene. Dies kann durch Verschrauben oder aber durch Bajonettverschlüsse odgl. erreicht werden. Eine weitere Möglichkeit ist ein kraftschlüssiges Zusammenhalten der Halteteile, wobei ein Kraftschluss unter Umständen leichter herstellbar sein kann als ein vorgenannter Formschluss. So kann ein Kraftschluss zwischen zwei Halteteilen beispielsweise durch berührungslose Kraftmittel erfolgen wie Unterdruck bzw. Vakuum oder Magnetkraft. Hierzu können beispielsweise bewegbare bzw. drehbare Magnete in beiden Halteteilen vorgesehen sein, die sich in einer Haltestellung anziehen und somit die beiden Halteteile zusammenhalten.

Gemäß einer weiteren erfindungsgemäßen Möglichkeit ist mindestens ein oberes Halteteil beweglich bzw. schwenkbar gelagert an dem Haltemittel bzw. an dem unteren Halteteil und kann zwischen einer Offen-Position und einer Halte-Position bewegt werden. In einer Halte-Position ist vorteilhaft das bewegbare obere Halteteil, insbesondere in der Nähe eines Randbereichs, gegen das untere Halteteil gedrückt.

In Ausgestaltung der Erfindung erstrecken sich das untere Halteteil und das obere Halteteil über die wesentliche Länge des an das Haltemittel heranragenden bzw. daran befestigten Abschnitts des Substrats. Dabei kann ein Halteteil, vorteilhaft das untere, etwas länger sein als das andere.

Vorteilhaft ist das wenigstens eine obere Halteteil in einer Halte-Position arretiert mit bzw. gegenüber dem unteren Halteteil. Eine solche Arretierung kann entweder als Fremdarretierung ausgebildet sein, beispielsweise durch separat betätigte Arretierungsstifte odgl.. Vorteilhaft sind die beiden Halteteile jedoch selbstarretierend in der Halte-Position arretiert, beispielsweise durch Einschieben des oberen Halteteils mit einer in Schieberichtung abfallenden Schräge unter eine korrespondierende Schräge am Haltemittel bzw. unteren Halteteil. Mit zunehmendem Einschieben des oberen Halteteils nimmt eine Verpressung gegen das untere Halteteil bzw. gegen einen dazwischen befindlichen Abschnitt des Substrats zu, so dass die Haltewirkung stärker wird.

Erfindungsgemäß sind nicht nur am vorderen und hinteren Ende eines Substrats Haltemittel vorgesehen, vorteilhaft gleichartige bzw. identische Haltemittel, sondern mehrere Substrate sind hintereinander nach Art einer Kette durch Haltemittel verbunden. Dabei ist vorgesehen, dass ein Haltemittel dazu ausgebildet ist, nicht nur ein Substrat zu halten, sondern zwei aufeinander folgende Substrate. Dabei wird es als vorteilhaft angesehen, wenn die beiden Substrate einen gewissen Abstand aufweisen, beispielsweise mindestens einige Millimeter bis einige Zentimeter.

Auf diese Art und Weise kann eine Art längerer Kette von Substraten geschaffen werden, die durch eine vorbeschriebene Behandlungseinrichtung geführt wird. Dabei wird diese Kette lediglich durch Verbindung der Haltemittel mit einer Transporteinrichtung gespannt und bewegt. Die Haltemittel können zum jeweils gleichartigen Verbinden mit einem vorderen und einem hinteren Ende eines Substrats ausgebildet sein. Besonders vorteilhaft ist bei einem mehrteiligen Haltemittel zumindest ein unteres Halteteil so breit, dass beide Substratenden an ihm befestigt sind bzw. aufliegen. Von oben können entweder zwei separate schmale obere Halteteile aufgelegt werden oder aber ein einziges Halteteil mit ähnlicher Breite wie das untere Halteteil.

Um Beschädigungen auch im Randbereich an den Substraten durch die Haltemittel zu vermeiden, können hier weiche Auflagebereiche nach Art von Gummistreifen, Gummilippen odgl. vorgesehen sein. In weiterer Ausgestaltung der Erfindung können diese eventuell sogar dichtend wirken derart, dass ein Bereich um Ausnehmungen in den Substraten, durch welche Vorsprünge der Halteteile greifen, so abgedichtet ist, dass Behandlungsflüssigkeit odgl. in der Behandlungseinrichtung nicht von einer Seite auf die andere Seite gelangen kann. Auch ein Bereich zwischen zwei Substraten kann so abgedichtet werden.

An einem seitlich über das Substrat überstehenden Ende kann ein Haltemittel so ausgebildet sein, dass es von der Transporteinrichtung gegriffen bzw. ergriffen werden kann. Hierzu können Ausnehmungen oder Vorsprünge vorgesehen sein. Bei beidseitig überstehenden Haltemitteln sind die Enden vorteilhaft gleichartig bzw. identisch ausgebildet.

Die seitlich überstehenden Enden der Haltemittel können in weiterer Ausgestaltung derart abgewinkelt oder abgebogen sein, dass sie über die Substratebene bzw. Transportebene nach oben überstehen. Dadurch kann die Transporteinrichtung bzw. die Befestigung der Haltemittel an der Transporteinrichtung über der Substratebene und somit beispielsweise über einem Flüssigkeitsniveau odgl. in der Behandlungseinrichtung liegen und trocken bleiben.

Die Transportvorrichtung weist für den Transport der Substrate bzw. das Ergreifen und Bewegen der Haltemittel mit den Substraten erfindungsgemäß zwei Bänder oder entsprechende Ketten links und rechts von einer Transportbahn auf, die umlaufen und Haltemittel bzw. Substrate in der Transportrichtung bewegen. Zur Befestigung der Haltemittel und speziell der Haltebügel weisen die Bänder oder Ketten Löcher auf. Des Weiteren kann eine Befestigung über Kraftschluss wie beispielsweise Magnetkraft erfolgen. Vorzugsweise ist eine Befestigung der Haltemittel an den Transporteinrichtungen zumindest entlang der Transportrichtung derart unverrückbar, dass die Haltemittel und somit auch die Reihe von aneinander befestigten Substraten quasi gespannt werden können bzw. quasi gespannt werden kann.

Ein Zusammenwirken der Substrate mit den Transporteinrichtungen und den Haltemitteln gemäß der Erfindung kann beispielsweise so aussehen, dass zwei Haltemittel mit Abstand an den Transporteinrichtungen befestigt werden und ein Substrat mit seinen beiden Enden an den Haltemitteln befestigt wird. Bei einem zweiteiligen Haltemittel erfolgt dies beispielsweise durch Auflegen des Substrats auf den unteren Halteteil des Haltemittels. Anschließend wird, falls es das erste Substrat von vielen ist, ein oberes Halteteil auf das erste untere Halteteil aufgelegt und somit die Verbindung des Substrats zu diesem Haltemittel fertiggestellt.

Dann wird mit passendem Abstand ein weiteres Haltemittel so an den Transporteinrichtungen befestigt, dass ein weiteres Substrat auf das erste Substrat folgend auf das zweite Haltemittel und das dritte Haltemittel aufgelegt wird. Dann wird mit einem oberen Halteteil am zweiten Haltemittel diese Verbindung fertiggestellt. Anschließend wird wiederum mit dem Abstand eines Substrats das nächste Haltemittel an den Transporteinrichtungen vorgesehen und dann wieder ein Substrat aufgelegt und am Haltemittel am vorderen Ende des zuletzt aufgelegten Substrats ein oberes Halteteil aufgelegt zur Fertigstellung der Verbindung. Dies wird kontinuierlich so gemacht, sodass jeweils beim Auflegen eines Substrats bereits die beiden Haltemittel vorhanden sind, auf die das Substrat mit seinen Enden gelegt wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein können. Die Unterteilung der Anmeldung in einzelne Abschnitte sowie Zwischen-Überschriften beschränkt die unter diesen gemachten Aussagen nicht in ihrer Allgemeingültigkeit. Die Erfindung wird durch die Ansprüche definiert.

Ausführungsbeispiele der Erfindung sind in den Zeichnungen schematisch dargestellt und werden im Folgenden näher erläutert. In den Zeichnungen zeigen:
- Fig. 1: eine Schrägansicht einer erfindungsgemäßen Transportvorrichtung mit Leiterplatten, die an erfindungsgemäßen Haltemitteln befestigt sind,
- Fig. 2: eine vergrößerte Darstellung eines Endes eines Haltebügels, der in eine Transportkette der erfindungsgemäßen Transportvorrichtungeingehängt ist,
- Fig. 3 und 4: eine schematische Seitenansicht eines Aufbaus eines zweiteiligen Haltebügels mit Verschraubung,
- Fig. 5: eine alternative Ausbildung eines zweiteiligen Haltebügels ähnlich Fig. 3 mit kraftschlüssiger Befestigung durch Magnete,
- Fig. 6 bis 11: ein Verfahren in mehreren Schritten zur Darstellung des Einbringens der Leiterplatten in die erfindungsgemäße Transportvorrichtung,
- Fig. 12: eine alternative Ausgestaltung von erfindungsgemäßen Haltemitteln mit Klemmbefestigung von Leiterplatten durch drehbare Bügel, und
- Fig. 13: eine weitere alternative Ausgestaltung von erfindungsgemäßen Haltemitteln mit einer selbstarretierenden Klemmung der Leiterplatten.

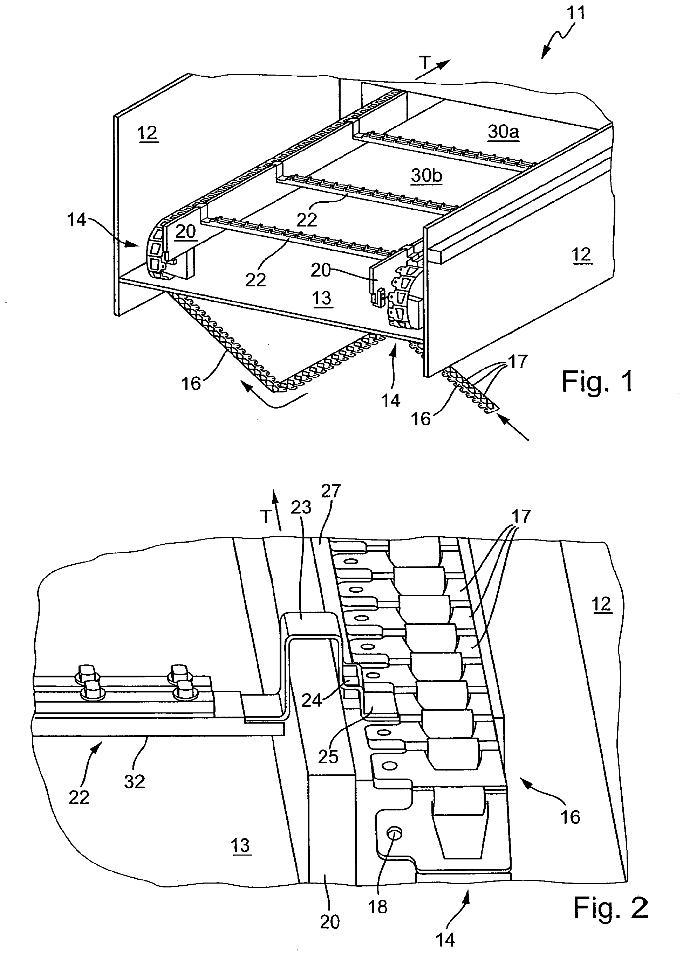

In Fig. 1 ist eine Transportvorrichtung 11 dargestellt mit einem durch zwei Seitenwände gebildeten Behandlungsbecken 12 mit Boden 13. Nach rechts hinten zu läuft die Transportvorrichtung 11 bzw. das Behandlungsbecken 12 entlang der Transportrichtung T in eine nicht dargestellte Anlage zur Behandlung von Leiterplatten, beispielsweise für einen Ätzschritt. In der Transportvorrichtung 11 bzw. im Behandlungsbecken 12 ist links außen und rechts außen jeweils eine Transporteinrichtung 14 vorgesehen mit je einer umlaufenden Transportkette 16. Wie insbesondere auch aus der Vergrößerung in Fig. 2 zu erkennen ist, bestehen die Transportketten 16 aus einzelnen Kettengliedern 17, welche an einem zu einem Mittelbereich des Behandlungsbeckens 12 hin weisenden Ende ein Loch 18 aufweisen. Gegenüber dem Mittelbereich des Behandlungsbeckens 12 sind die Transportketten 16 über Innenwände 20 abgeschirmt. Die Innenwände 20 können dabei unter Umständen sogar bis auf den Boden 13 des Behandlungsbeckens 12 gehen und damit eine Art inneres Becken bilden. Alternativ können sie auch, wie dargestellt, nur gegen Anschwappen der Transportketten 16 mit Behandlungsflüssigkeit oder auch zu anderen Zwecken dienen.

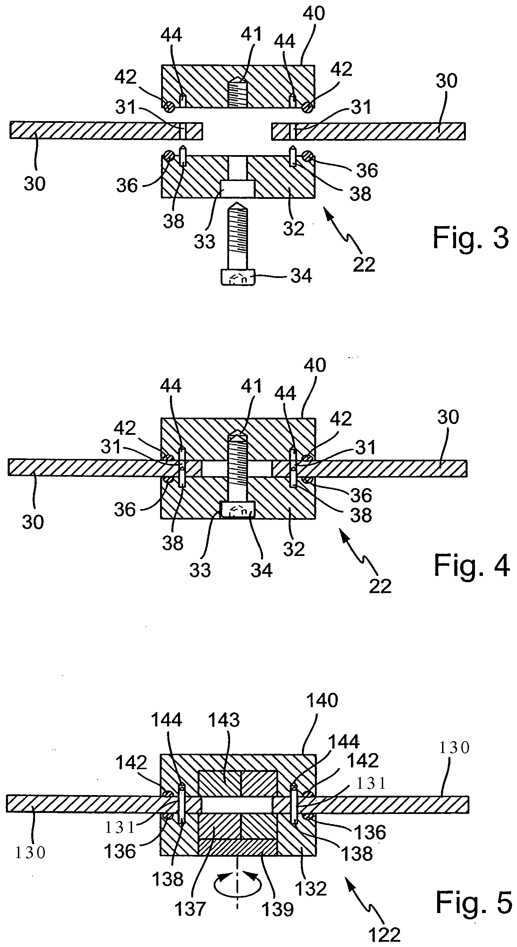

Zwischen den Transportketten 16 sind als Haltemittel Haltebügel 22 eingehängt. Diese werden nachfolgend in den Fig. 3 bis 5 näher dargestellt und erläutert. Die Haltebügel 22 überbrücken den Zwischenraum zwischen den Innenwänden 20. An ihrem Ende weisen sie abgewinkelte Halteabschnitte 23 auf, die beispielsweise als Flachstahl von den Haltebügeln 22 ausgehend rechtwinklig nach oben gebogen sind, dann wiederum nach außen über die Innenwände 20 hinüber und hinter diesen wieder mit einer Zwischenstufe zu einem waagerechten Ende 25 verlaufen. Wie dargestellt, können in der Zwischenstufe Rollen 24 odgl. angeordnet sein, mit denen der Halteabschnitt 23 und somit der Haltebügel 22 auf einer Schiene 27 läuft und von dieser getragen wird. Anstelle von Rollen 24 können auch Gleitlager odgl. aus entsprechend geeignetem Material vorgesehen sein. Somit liegt das Gewicht der Haltebügel 22 auf den Schienen 27 auf.

Für die Bewegung sorgt ein nicht dargestellter, von dem Ende 25 nach unten abstehender Vorsprung, der in das Loch 18 des entsprechenden Kettengliedes 17 eingreift bzw. eingesteckt ist. So kann vorgesehen sein, dass die Transportketten 16 lediglich für die Kraft zur Durchführung der Transportbewegung ausgelegt sein müssen, während das Gewicht der Haltebügel 22 samt ihrer Last von den Schienen 27 getragen wird. Selbstverständlich ist es auch in leichter Abwandlung möglich, dass die Transportketten 16 zusätzlich noch das Gewicht der Haltebügel 22 tragen, diese also auf den Transportketten 16 bzw. den Kettengliedern 17 abgestützt sind.

In Fig. 1 rechts hinten sind eine erste Leiterplatte 30a und eine zweite Leiterplatte 30b dargestellt. Diese sind bereits an den Haltebügeln 22 befestigt und können von den Transporteinrichtungen 14 nach rechts hinten in eine Behandlungsanlage eingefahren werden. Die genaue Art der Befestigung wird nachfolgend erläutert.

In Fig. 3 ist in Seitenansicht ein zweiteilig ausgebildeter Haltebügel 22 dargestellt, und zwar mit einem unteren Halteteil 32 und einem oberen Halteteil 40. Das untere Halteteil 32 weist eine Schraubenbohrung 33 auf zum Durchgriff einer von unten herangeführten Schraube 34. Des Weiteren sind in der Oberseite des unteren Halteteils 32 ganz außen verlaufend untere Gummilippen 36 eingelassen sowie Stifte 38, die an ihrer Oberseite verjüngt sind.

Wie zu erkennen ist, weisen Leiterplatten 30 Durchbohrungen 31 auf, die beim Aufsetzen, wie in Fig. 4 dargestellt ist, über die Stifte 38 greifen. Somit ist eine Leiterplatte 30 durch Aufsetzen auf das untere Halteteil 32 zumindest in seiner Ebene formschlüssig damit verbunden. Wie aus Fig. 3 deutlich zu entnehmen ist, kann über den Haltebügel 22 eine Verbindung zweier Leiterplatten 30 erfolgen, nach Art einer Kette.

Damit die Stifte 38 nicht aus den Durchbohrungen 31 der Leiterplatten 30 herausrutschen können bzw. die Verbindung nicht wieder getrennt werden kann, wird das obere Halteteil 40 von oben auf das untere Halteteil 32 aufgesetzt. Das obere Halteteil 40 weist eine Gewindebohrung 41 auf sowie obere Gummilippen 42 und Bohrungen 44, die genau den unteren Gummilippen 36 und den Stiften 38 des unteren Halteteils 32 gegenüberliegen. In Fig. 4 ist zu erkennen, wie durch Anziehen der Schraube 34 das untere Halteteil 32 und das obere Halteteil 40 sehr weit bzw. unter Umständen sogar vollständig gegeneinander angezogen werden können. Die Auflage der Leiterplatten 30 kann dabei auf die unteren Gummilippen 36 beschränkt sein, muss es jedoch nicht.

Des Weiteren ist in Fig. 4 dargestellt, dass die Stifte 38 nicht in die Bohrungen 44 des oberen Halteteils 40 eingreifen. Dies kann jedoch problemlos vorgesehen sein, da dadurch das Ansetzen der Leiterplatten 30 an das untere Halteteil 32 nicht beeinträchtigt wird und das passgenaue Aufsetzen des oberen Halteteils 40 ohnehin notwendig ist.

Somit ist gemäß der Fig. 3 und 4 gezeigt, wie zur Befestigung von Leiterplatten 30 an einen Haltebügel 22 zweiteilige Haltebügel mit einem unteren Halteteil 32 und einem oberen Halteteil 40 vorgesehen sein können. Aus dem Vergleich mit den Fig. 1 und 2 ist zu erkennen, dass die unteren Halteteile 32 nahezu bis an die Innenwände 20 reichen, während die oberen Halteteile 40 etwas kürzer sein können, da ihre Aufgabe eigentlich nur darin besteht, die Fixierung bzw. Sicherung der Leiterplatten 30 an dem die Halterung eigentlich bildenden unteren Halteteil 32 sicherzustellen. In Längserstreckung der Haltebügel 22 können bereits zwei Schrauben 34 ausreichen, genügend eigenstabile Halteteile so miteinander zu verbinden, dass sie die Leiterplatten 30 sicher halten. So kann der Aufwand für die Fertigstellung der Verbindung gesenkt werden. Des Weiteren ist es selbstverständlich möglich, dass die Schrauben 34 auch von oben in die Haltebügel 22 eingreifen können. Alternativ zu Schrauben sind auch mechanische Schnellverschlüsse wie beispielsweise Bajonettverschlüsse odgl. möglich. Ebenso kann anhand von Fig. 4 erkannt werden, dass bei Sicherstellung der Dichtwirkung der unteren Gummilippe 36 und der oberen Gummilippe 42 gegenüber den Leiterplatten 30 und dem unteren Halteteil 32 und dem oberen Halteteil 40 ein Unterdruck in dem Raum zwischen den Enden der Leiterplatten erzeugt werden kann. Anstelle der Schrauben 34 sind dann geeignete Ventile vorzusehen, die beispielsweise einen Unterdruck nach seinem Erzeugen in dem Zwischenraum halten zum Anpressen der Halteteile.

In Fig. 5 ist eine alternative Ausgestaltung eines Haltebügels 122 dargestellt, der wiederum aus einem unteren Halteteil 132 und einem oberen Halteteil 140 besteht. Das untere Halteteil 132 weist wiederum Stifte 138 und untere Gummilippen 136 auf. Auch das obere Halteteil 140 weist wiederum obere Gummilippen 142 und Bohrungen 144 für die Stifte 138 auf. Die Leiterplatten 130 weisen Durchbohrungen 131 auf, die beim Aufsetzen, wie in Fig. 5 dargestellt ist, über die Stifte 138 greifen. Hier sind die Stifte 138 jedoch so lange, dass sie deutlich über die Höhe der Leiterplatten 130 hinausgehen, diese dabei durchgreifen und in die Bohrungen 144 des oberen Halteteils 140 eingreifen.

Anstelle einer formschlüssigen Befestigung des unteren Halteteils 32 und des oberen Halteteils 40 aneinander wie in Fig. 4 sind in Fig. 5 ein unterer Haltemagnet 137 und ein oberer Haltemagnet 143 vorgesehen. Diese sind gegensinnig gepolt, so dass sie sich anziehen und somit das untere Halteteil 132 und das obere Halteteil 140 mittels der Stifte 138 in den Bohrungen 144 fest verbinden. Zum einfachen Lösen der Verbindung kann vorgesehen sein, dass der obere Haltemagnet 143 fest in dem oberen Halteteil 140 sitzt. Der untere Haltemagnet 137 kann um eine Drehachse parallel zu den Stiften 138 gedreht werden, wie durch den Drehpfeil verdeutlicht wird. Dazu sind Griffteile 139 vorgesehen, die manuell oder bevorzugt maschinell gedreht werden können. In nochmals weiterer Ausgestaltung der Erfindung ist es sogar möglich, dass sich magnetische bzw. magnetisierbare Teile der Halteteile im Zwischenraum zwischen den Leiterplatten 130 berühren, wodurch die Magnetkraft bzw. die daraus resultierende Haltekraft nochmals gesteigert werden kann. Ähnlich wie vorstehend für die Schrauben beschrieben, kann selbstverständlich auch bei einer Befestigung durch Magnetkraft vorgesehen sein, dass der drehbare Magnet nicht im unteren Halteteil 132, sondern im oberen Halteteil 140 vorgesehen ist und von oben erreichbar ist.

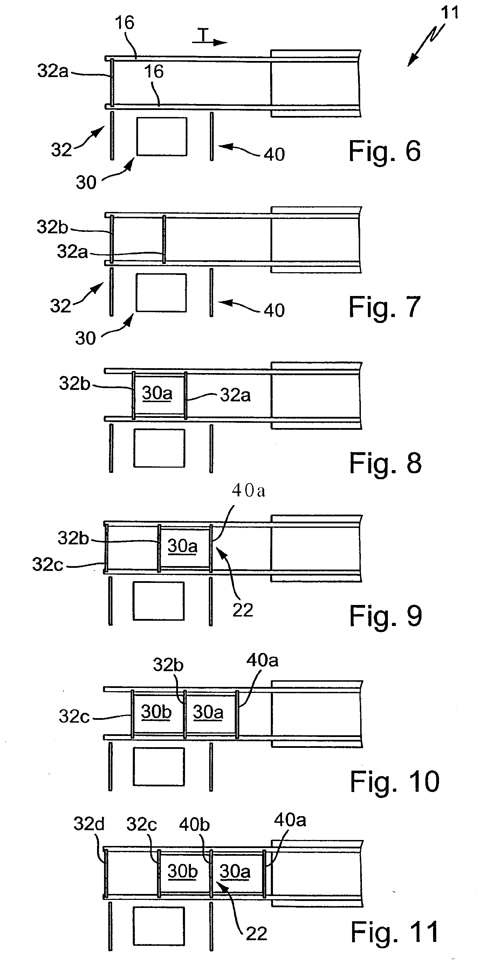

Die einzelnen Schritte des Verfahrens zum Einbringen der Leiterplatten 30 in die Transportvorrichtung 11 sind in den Fig. 6 bis 11 dargestellt. In Fig. 6 ist zu erkennen, dass auf die Transportketten 16 ein erstes unteres Halteteil 32a aufgesetzt wird, wie es beispielsweise in Fig. 2 dargestellt ist.

In Fig. 7 sind im Vergleich zu Fig. 6 die Transportketten 16 ein Stück in Transportrichtung T bewegt worden, so dass das aufgelegte erste untere Halteteil 32a schon weiter rechts liegt. Im Abstand ungefähr einer Länge einer Leiterplatte wird dann ein zweites unteres Halteteil 32b auf die Transportketten 16 aufgesetzt.

In Fig. 8 ist dargestellt, wie die Transportketten 16 wiederum in Transportrichtung T bewegt worden sind und auf das erste untere Halteteil 32a und das zweite untere Halteteil 32b eine erste Leiterplatte 30a aufgesetzt ist gemäß Fig. 3.

In Fig. 9 ist dargestellt, wie nach weiterem Bewegen der ersten Leiterplatte 30a in der Transportrichtung T ein drittes unteres Halteteil 32c auf die Transportketten 16 aufgesetzt worden ist. Der Abstand ist wiederum so, dass dann im nächsten Schritt eine weitere Leiterplatte genau aufgesetzt werden kann. Des Weiteren ist auf das erste untere Halteteil 32a ein erstes oberes Halteteil 40a aufgesetzt worden, um hier die Verbindung gemäß Fig. 4 fertigzustellen.

In Fig. 10 ist dargestellt, wie die Transportketten 16 erneut ein Stück in die Transportrichtung T bewegt worden sind und eine zweite Leiterplatte 30b auf das zweite untere Halteteil 32b und das dritte untere Halteteil 32c passend aufgelegt worden ist.

Im nächsten Schritt gemäß Fig. 11 wurden die Transportketten 16 wiederum weiter in Transportrichtung T bewegt und ein viertes unteres Halteteil 32d daraufgesetzt mit dem gleichen Abstand wie zuvor die unteren Halteteile. Des Weiteren ist auf das zweite untere Halteteil 32b, also zwischen die erste Leiterplatte 30a und die zweite Leiterplatte 30b, ein zweites oberes Halteteil 40b aufgesetzt worden zur Fertigstellung dieser Verbindung.

Dieses Verfahren wird so weiter durchgeführt wie aus den beschriebenen Schritten zu entnehmen ist. Jeweils aus den unterhalb den Transportketten 16 dargestellten Vorräten von unteren Halteteilen 32, Leiterplatten 30 und oberen Halteteilen 40 wird eines genau an dieser Stelle auf die Transportketten 16 aufgelegt bzw. daran befestigt. Auf diese Art und Weise ist es gemäß der Erfindung möglich, sehr dünne bzw. mechanisch empfindliche Leiterplatten 30 so zu haltern bzw. einzuspannen, dass sie problemlos mit einer Transportvorrichtung 11 durch ein Behandlungsbecken 12 bzw. eine entsprechende Anlage gefahren werden können und eine Behandlung vorgenommen werden kann ohne die Leiterplatten zu beschädigen, in ihrer Orientierung zu ändern oder sonstige Probleme zu bewirken.

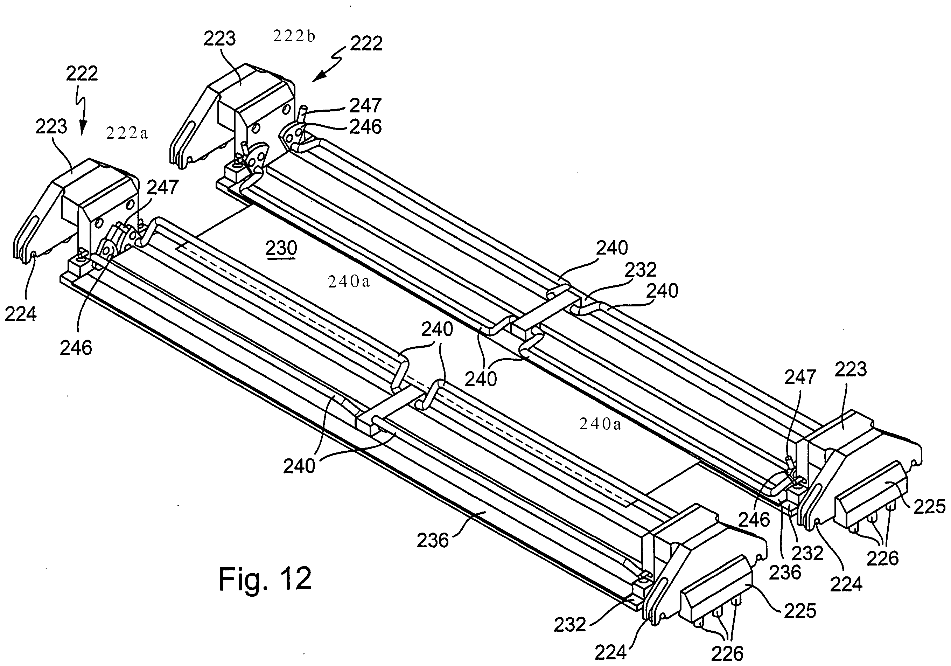

In Fig. 12 sind zwei alternative Haltebügel 222 mit vorbeschriebenen, unteren Halteteilen 232 dargestellt. An den Enden weisen sie an Halteabschnitten 223 Rollen 224 auf in einer Art Schlittenlagerung. Seitlich außerhalb der Schlittenlagerungen für die Rollen 224 sind Enden 225 vorgesehen mit nach unten ragenden Stiften 226. Die Rollen 224 können auf einer Schiene 27 entsprechend Fig. 2 entlang laufen. Die Stifte 226 greifen dabei in die Löcher 18 der Kettenglieder 17 der Transportketten 16 gemäß Fig. 2 ein zum Transport wie vorbeschrieben.

Die unteren Halteteile 232 erstrecken sich, ähnlich wie zuvor beschrieben, über die gesamte Breite der Transportvorrichtung 11 und sind beispielsweise nach Art eines flachen Trägers oder einer flachen, aber ausreichend stabilen und länglichen Platte ausgebildet. Sie weisen vorteilhaft aber nicht zwingend einen zentralen Längsträger auf als eine Art Verstärkungsrippe.

Obere Halteteile 240 sind nach Art von drehbaren, durchgehenden Bügeln an den unteren Halteteilen 232 gelagert, und zwar an äußeren Drehlagerungen 246 am Ende nahe der Halteabschnitte 223 sowie mittig dazwischen. An den äußeren Drehlagerungen 246 sind nach oben weisende Bedienhebel 247 vorgesehen, die maschinell oder von Hand ergriffen werden können zum Drehen der oberen Halteteile 240. An dem linken Haltebügel 222a ist zu erkennen, wie die oberen Halteteile 240 nach oben bzw. in eine Offen-Position gedreht sind durch Drehen der Bedienhebel 247 aufeinander zu. Diese Offen-Position kann auch daran erkannt werden, dass an den linken Haltebügel 222a von rechts eine Leiterplatte 230 herangeführt ist welche das untere Halteteil 232 des linken Haltebügels 222a ein Stück überlappt. Hierbei ist zu erkennen, dass über die Breite der unteren Halteteile 232 Gummistreifen 236 vorgesehen sind, die den zuvor beschriebenen unteren Gummilippen 36 gemäß Fig. 3 entsprechen. Diese Gummistreifen 236 verhindern ein Verkratzen der Leiterplatten und vor allem unterstützen sie eine Klemmbefestigung.

Am rechten Haltebügel 222b ist zu erkennen, wie die Bedienhebel 247 im Vergleich zum linken Haltebügel 222a voneinander weg gedreht worden sind. Dadurch werden die oberen Halteteile 240 gedreht und gegen das untere Halteteil 232 bzw. die Gummistreifen 236 am Rand gedrückt. Dabei klemmen die linken oberen Halteteile 240a des rechten Haltebügels 222b die Leiterplatte 230 entlang nahezu ihrer gesamten Breite ein bzw. fest, und zwar durch Drücken gegen den Gummistreifen 236 und somit gegen den Randabschnitt des unteren Halteteils 232. Dies ist die Halte-Position. Damit sich die oberen Halteteile 240 nicht wieder zurückdrehen und die Leiterplatte 230 freigeben, ist an den äußeren Drehlagerungen 246 eine nicht dargestellte Arretierung vorgesehen, beispielsweise nach Art eines von hinten durchgeschobenen Stiftes odgl., zum Beispiel sowohl in der Offen-Position als auch in der Halte-Position. Auch die Bedienhebel 247 am äußeren Ende der Haltebügel 222 können arretiert werden gegen ein Zurückbewegen.

Somit zeigt die in Fig. 12 dargestellte Vorrichtung Haltebügel 222, die als eine Baueinheit ausgebildet sind und deren Teile unverlierbar sind, so dass nicht mehrere Teile zusammengefügt werden müssen wie nach Fig. 1 bis 5. Des weiteren sind die oberen Halteteile 240 drehbeweglich mit einer reinen Drehbewegung, wobei sie in der Halte-Position nicht selbstarretierend sind, sondern arretiert werden müssen.

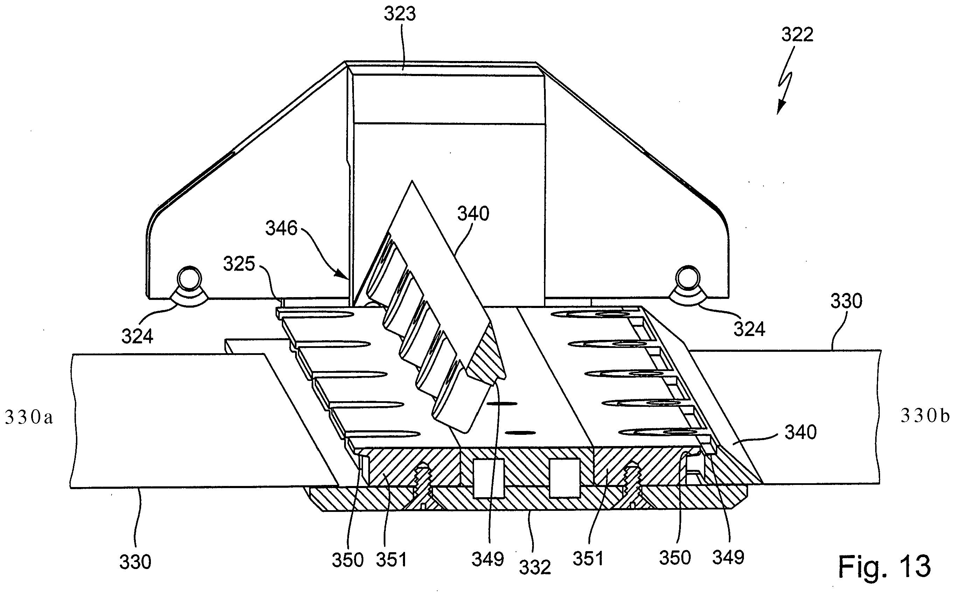

In Fig. 13 ist ein weiterer Haltebügel 322 dargestellt mit einem unteren Halteteil 332 sowie einem Halteabschnitt 323, Rollen 324 sowie, entsprechend Fig. 12, an einem Ende 325 nicht zu sehende Stifte zum Befestigen an einer Transportkette 16 gemäß Fig. 2. Ähnlich wie bei der Vorrichtung gemäß Fig. 12 sind an dem Haltebügel 322 obere Halteteile 340 unverlierbar vorgesehen, und zwar schwenkbar gelagert an einer Schwenklagerung 346. Gleichzeitig ist jedoch, was einfach vorstellbar ist, diese Schwenklagerung 346 nicht als ausschließlich zwingende Drehlagerung ausgebildet, sondern das obere Halteteil 340 links in Fig. 13 kann aus der dargestellten Offen-Position entgegen dem Uhrzeigersinn geschwenkt werden, bis es am unteren Halteteil 332 bzw. der herangeführten linken Leiterplatte 330a aufliegt. Anschließend kann das obere Halteteil 340 mit einem Klemmabschnitt 349 unter einen Klemmübergriff 350 einer Führung 351 am unteren Halteteil 332 geschoben und somit geklemmt werden nach Art von Keilen.

Der Klemmabschnitt 349 wie auch der Klemmübergriff 350 sind schräg im Vergleich zur Ebene des unteren Halteteils. Je weiter das obere Halteteil 340 mit dem Klemmabschnitt 349 in die Führung 351 und unter den Klemmübergriff 350 hineingeschoben wird, desto stärker wird die Klemmwirkung und aufgrund der schiefen Ebene auch die Andruckkraft, mit der die linke Leiterplatte 330a zwischen oberem Halteteil 340 und unterem Halteteil 332 festgeklemmt bzw. festgehalten wird. In Fig. 13 rechts ist dargestellt, wie nach dem reinen Drehen des oberen Halteteils 340 nun das Einschieben in die Führung 351 erfolgt zum Festklemmen der rechten Leiterplatte 330b. Für diese Schwenkbeweglichkeit kann ein Achsstummel am unteren Halteteil 332 vorgesehen sein, der in einen Schlitz im oberen Halteteil 340 eingreift. So kann er in dem Schlitz sowohl gedreht werden als auch verschoben werden. Derartige Lagerungen sind dem Fachmann grundsätzlich bekannt.

Der Vorteil des Haltebügels 322 gemäß Fig. 13 gegenüber dem vorbeschriebenen Haltebügel 222 gemäß Fig. 12 ist der, dass es sich um eine selbstarretierende bzw. selbsthemmende Befestigung handelt. Nach starkem Eindrücken der oberen Halteteile 340 in die Führung 351 sind diese fixiert und können sich nicht von selbst wieder lösen, und damit werden auch die Leiterplatten 330 gehalten.

Das vorbeschriebene Verfahren zum Einbringen der Leiterplatten 30 in die Transportvorrichtung 11 kann mit den Haltebügeln gemäß Fig. 5, Fig. 12, und Fig. 13 analog erfolgen. Die Leiterplatten können also nacheinander aufgelegt und somit gehaltert werden. Allerdings werden die oberen Halteteile gemäß Fig. 12 und Fig. 13 nicht extra herangeführt, sondern nach unten gedreht bzw. geschwenkt. Auch hier ist alternativ eine Halterung der Leiterplatten an den Haltemitteln separat von der Transportvorrichtung möglich.

## Patentansprüche

1. Haltemittel für eine Transportvorrichtung (11) zum Transport von dünnen flächigen Substraten, insbesondere Leiterplatten (30; 130; 230; 330), durch ein Behandlungsbecken (12), wobei die Haltemittel als Haltebügel (22; 122; 222; 322) zum festen Verbinden mit einem dünnen flächigen Substrat und zum Verbinden bzw. mechanischen Koppeln von zwei in Transportrichtung (T) der dünnen flächigen Substrate aufeinanderfolgenden dünnen flächigen Substraten miteinander ausgebildet sind, und wobei die Haltebügel (22; 122; 222; 322) an beiden Seiten über die Breite der dünnen flächigen Substrate quer zur Transportrichtung (T) überstehen und dazu ausgebildet sind, mit einer Transporteinrichtung (14) der Transportvorrichtung (11) zusammenzuwirken zum Transport der dünnen flächigen Substrate durch das Behandlungsbecken (12), **dadurch gekennzeichnet, dass** die Haltebügel (22; 122; 222; 322) als mindestens zweiteilige Haltebügel ausgebildet sind mit einem unteren Halteteil (32; 132; 232; 332) und einem oberen Halteteil (40; 140; 240; 340), die zum Befestigen eines dünnen flächigen Substrats dazwischen ausgebildet sind.

2. Haltemittel nach Anspruch 1, **dadurch gekennzeichnet, dass** quer zur Transportrichtung (T) das untere Halteteil (32; 132; 232; 332) und das obere Halteteil (40; 140; 240; 340) gleich lang sind oder das untere Halteteil (32; 132; 232; 332) etwas über das obere Halteteil (40; 140; 240; 340) übersteht.

3. Haltemittel nach Anspruch 1 oder 2, **dadurch gekennzeichnet, dass** die Haltebügel (22; 122) für eine formschlüssige Verbindung bzw. einen formschlüssigen Eingriff mindestens eines Stifts (38; 138) in eine Durchbohrung (31; 131) in einem dünnen flächigen Substrat ausgebildet sind.

4. Haltemittel nach Anspruch 3, **dadurch gekennzeichnet, dass** wenigstens ein unteres Halteteil (32; 132) mit Stiften (38; 138) zum Eingreifen in ein dünnes flächiges Substrat versehen ist, wobei vorzugsweise die Stifte (38; 138) durch das dünne flächige Substrat reichen und auf der anderen Seite derart überstehen, dass sie in entsprechende Bohrungen (44; 144) in ein oberes Halteteil (40; 140) eingreifen.

5. Haltemittel nach einem der Ansprüche 1 bis 4, **dadurch gekennzeichnet, dass** die Haltebügel (22; 122) für einen Kraftschluss zwischen dem unteren und dem oberen Halteteil (32, 40; 132, 140) durch berührungslose Kraftmittel, vorzugsweise durch Magnetkraft oder Vakuum, ausgebildet sind.

6. Haltemittel nach einem der vorhergehenden Ansprüche, **dadurch gekennzeichnet, dass** die Haltebügel (22; 122; 222; 322) zum gleichartigen Verbinden ausgebildet sind, wobei das untere Halteteil (32; 132; 232; 332) ausgebildet ist zur Auflage von zwei dünnen flächigen Substraten an jeweils gegenüberliegenden Längsseiten des unteren Halteteils (32; 132; 232; 332).

7. Haltemittel nach Anspruch 1 oder 2, **dadurch gekennzeichnet, dass** wenigstens ein oberes Halteteil (240; 340) beweglich oder schwenkbar gelagert ist an einem unteren Halteteil (232; 332) zwischen einer Offen-Position und einer Halte-Position, wobei vorzugsweise in der Halte-Position das wenigstens eine obere Halteteil (240; 340) gegen das untere Halteteil (232; 332) gedrückt ist und das wenigstens eine obere Halteteil (240; 340) in der HaltePosition arretiert ist an dem unteren Halteteil (232; 332).

8. Haltemittel nach Anspruch 7, **dadurch gekennzeichnet, dass** das wenigstens eine obere Halteteil (340) in der Halte-Position durch Selbstarretierung arretiert ist, insbesondere durch Einschieben des wenigstens einen oberen Halteteils (340) mit einem in Schieberichtung abfallenden Klemmabschnitt (349) unter einen korrespondierenden Klemmübergriff (350) am unteren Halteteil (332), wobei mit zunehmendem Einschieben des wenigstens einen oberen Halteteils (340) eine Verpressung gegen das untere Halteteil (332) bzw. gegen einen dazwischen befindlichen Abschnitt eines dünnen flächigen Substrats zunimmt.

9. Haltemittel nach Anspruch 6, **dadurch gekennzeichnet, dass** die Haltebügel (22; 122) gegenüber den daran befestigten dünnen flächigen Substraten abgedichtet sind durch an den unteren und den oberen **Halteteilen** (32, 40; 132, 140) angeordnete untere und obere Gummilippen (36, 42; 136, 142) wobei das untere und das obere Halteteil (32, 40; 132, 140) gegen ein dünnes flächiges Substrat weitgehend abgedichtet sind.

10. Haltemittel nach einem der vorhergehenden Ansprüche, **dadurch gekennzeichnet, dass** die Haltebügel (22; 122; 222; 322) mit Enden (25; 225; 325), die seitlich über die Erstreckung der dünnen flächigen Substrate quer zur Transportrichtung (T) überstehen, ergreifbar sind zum Transport der dünnen flächigen Substrate, wobei vorzugsweise die Enden (25; 225; 325) der Haltebügel (22; 122; 222; 322) abgewinkelt sind und daran vorgesehene Stiftteile (226) ein Stück über einer Transportebene der dünnen flächigen Substrate angeordnet sind.

11. Transportvorrichtung (11) mit Haltemitteln nach einem der vorhergehenden Ansprüche, **dadurch gekennzeichnet, dass** die Transportvorrichtung (11) für die dünnen flächigen Substrate bzw. die Haltebügel (22; 122; 222; 322) links und rechts von einer Transportbahn für die dünnen flächigen Substrate jeweils eine Transporteinrichtung (14) mit je einem umlaufenden und teilweise in Transportrichtung (T) der dünnen flächigen Substrate laufenden Band oder einer entsprechenden Transportkette (16) aufweist mit Löchern (18) zur Befestigung der Haltebügel (22; 122; 222; 322) daran.

12. Verfahren zum Transport von dünnen flächigen Substraten in einer Transportrichtung (T) mit einer Transportvorrichtung (11) nach Anspruch 11, wobei an den Transporteinrichtungen (14) der Transportvorrichtung (11) zumindest ein erstes Haltemittel und ein zweites Haltemittel mit einem derartigen Abstand in Transportrichtung (T) der dünnen flächigen Substrate vorgesehen sind, dass ein erstes dünnes flächiges Substrat beim Auflegen auf das erste und das zweite Haltemittel mit Endbereichen auf dem ersten und dem zweiten Haltemittel bzw. auf einem ersten unteren Halteteil (32a) des ersten Haltemittels und einem zweiten unteren Halteteil (32b) des zweiten Haltemittels aufliegt, danach auf das zweite untere Halteteil (32b) des zweiten Haltemittels und ein weiteres drittes unteres Halteteil (32c) eines dritten Haltemittels ein zweites dünnes flächiges Substrat mit Endbereichen aufgelegt wird, und danach auf die Endbereiche des ersten dünnen flächigen Substrats und die Endbereiche des zweiten dünnen flächigen Substrats ein erstes oberes Halteteil (40a) des ersten Haltemittels bzw. ein zweites oberes Halteteil (40b) des zweiten Haltemittels auf das erste untere Halteteil (32a) des ersten Haltemittels bzw. das zweite untere Halteteil (32b) des zweiten Haltemittels aufgelegt werden und eine mechanische Halterung des ersten dünnen flächigen Substrats und des zweiten dünnen flächigen Substrats an den ersten bis dritten Haltemitteln erfolgt zum Verhindern eines selbsttätigen Lösens des ersten dünnen flächigen Substrats und des zweiten dünnen flächigen Substrats von den ersten bis dritten Haltemitteln, und wobei danach eine Bewegung des ersten dünnen flächigen Substrats und des zweiten dünnen flächigen Substrats. an den ersten bis dritten Haltemitteln der Transportvorrichtung (11) in Transportrichtung (T) des ersten dünnen flächigen Substrats und des zweiten dünnen flächigen Substrats erfolgt zum Transport des ersten dünnen flächigen Substrats und des zweiten dünnen flächigen Substrats.

13. Verfahren nach Anspruch 12, **dadurch gekennzeichnet, dass** das untere und das obere Halteteil (32, 40) beim Transport eines dünnen flächigen Substrats zusammengehalten werden.

14. Verfahren nach Anspruch 12 oder 13, **dadurch gekennzeichnet, dass** das untere Halteteil (32) und das obere Halteteil (40) beim Transport eines dünnen flächigen Substrats kraftschlüssig zusammengehalten werden.

## Claims

1. Holding means for a conveying device (11) for conveying thin flat substrates, in particular circuit boards (30; 130; 230; 330), through a treatment tank (12), said holding means being constructed as holding clips (22; 122; 222; 322) for a fixed connection to a thin flat substrate and for connecting or mechanically coupling together two thin flat substrates successive in the conveying direction (T) of said thin flat substrates, and said holding clips (22; 122; 222; 322) projecting on both sides beyond the width of the thin flat substrates transversely to the conveying direction (T) and being constructed for cooperating with a conveying unit (14) of the conveying device (11) for conveying said thin flat substrates through said treatment tank (12),
**characterized in that**
the holding clips (22; 122; 222; 322) are constructed in at least two-part holding clips with a lower holding part (32; 132; 232; 332) and an upper holding part (40; 140; 240; 340), the holding parts being constructed for fastening a thin flat substrate between them.

2. Holding means according to claim 1, **characterized in that**, transversely to the conveying direction (T), the lower holding part (32; 132; 232; 332) and the upper holding part (40; 140; 240; 340) are of equal length or the lower holding part (32; 132; 232; 332) projects somewhat beyond the upper holding part (40; 140; 240; 340).

3. Holding means according to claim 1 or 2, **characterized in that** the holding clips (22; 122) are constructed for a positive connection or a positive engagement of at least one pin (38; 138) in a through hole (31; 131) in a thin flat substrate.

4. Holding means according to claim 3, **characterized in that** at least one lower holding part (32; 132) is provided with pins (38; 138) for engaging in a thin flat substrate, wherein preferably the pins (38; 138) pass through the thin flat substrate and project on the other side in such a way that they engage in corresponding recesses (44; 144) in an upper holding part (40; 140).

5. Holding means according to any of the claims 1 to 4, **characterized in that** the holding clips (22; 122) are constructed for a force closure between the lower and the upper holding parts (32, 40; 132, 140) by non-contact force means, preferably by magnetic force or vacuum.

6. Holding means according to any of the preceding claims, **characterized in that** the holding clips (22; 122; 222; 322) are constructed for identical connection, wherein the lower holding part (32; 132; 232; 332) is constructed for placing two thin flat substrates in each case on opposite longitudinal sides of the lower holding part (32; 132; 232; 332).

7. Holding means according to claim 1 or 2, **characterized in that** at least one upper holding part (240; 340) is movably or pivotably mounted on a lower holding part (232; 332) between an open position and a holding position, wherein preferably in the holding position the at least one upper holding part (240; 340) is urged against the lower holding part (232; 332) and the at least one upper holding part (240; 340) in the holding position is locked on said lower holding part (232; 332).

8. Holding means according to claim 7, **characterized in that** the at least one upper holding part (340) is locked in the holding position in self-locking manner, in particular by inserting the at least one upper holding part (340) with a clamping portion (349), sloping in the sliding direction, under a corresponding clamping bevel (350) on the lower holding part (332), wherein with increasing insertion of the at least one upper holding part (340) a pressing against the lower holding part (332) or against an intermediate portion of a thin flat substrate increases.

9. Holding means according to claim 6, **characterized in that** the holding clips (22; 122) are sealed against the thin flat substrates fastened thereto by lower and upper rubber lips (36, 42; 136, 142) provided on the lower and the upper holding parts (32, 40; 132, 140), wherein the lower and the upper holding parts (32, 40; 132, 140) are largely sealed against a thin flat substrate.

10. Holding means according to any of the preceding claims, **characterized in that** the holding clips (22; 122; 222; 322), by ends (25; 225; 325) projecting laterally beyond the extension of the thin flat substrates transversely to the conveying direction (T), can be gripped for conveying the thin flat substrates, wherein preferably the ends (25; 225; 325) of the holding clips (22; 122; 222; 322) are angled and pin parts (226) provided thereon are located somewhat above a conveying plane of the thin flat substrates.

11. Conveying device (11) with holding means according to any of the preceding claims, **characterized in that** the conveying device (11) for the thin flat substrates and/or the holding clips (22; 122; 222; 322) to the left and to the right of a conveying path for the thin flat substrates each have a conveying unit (14) with a respective revolving belt partly running in the conveying direction (T) of the thin flat substrates or a corresponding conveying chain (16) with holes (18) for fastening the holding clips (22; 122; 222; 322) thereto.

12. Method for conveying thin flat substrates in a conveying direction (T) using a conveying device (11) according to claim 11, wherein on the conveying units (14) of the conveying device (11) at least one first holding means and one second holding means are provided with such a mutual spacing in the conveying direction (T) of the thin flat substrates that a first thin flat substrate, when placed onto the first and the second holding means, rests with end regions on the first and the second holding means or on a first lower holding part (32a) of the first holding means and a second lower holding part (32b) of the second holding means, subsequently onto the second lower holding part (32b) of the second holding means and a further third lower holding part (32c) of a third hold means is placed a second thin flat substrate with end regions, and subsequently onto the end regions of the first thin flat substrate and the end regions of the second thin flat substrate a first upper holding part (40a) of the first holding means or a second upper holding part (40b) of the second holding means are placed onto the first lower holding part (32a) of the first holding means or the second lower holding part (32b) of the second holding means and a mechanical holding of the first thin flat substrate and the second thin flat substrate takes place on the first to third holding means to prevent an automatic release of the first thin flat substrate and the second thin flat substrate from the first to third holding means, and wherein subsequently a movement of the first thin flat substrate and the second thin flat substrate on the first to third holding means of the conveying device (11) in the conveying direction (T) of the first thin flat substrate and the second thin flat substrate takes place for conveying the first thin flat substrate and the second thin flat substrate.

13. Method according to claim 12, **characterized in that** the lower and the upper holding parts (32, 40) are held together during conveying of a thin flat substrate.

14. Method according to claim 12 or 13, **characterized in that** the lower holding part (32) and the upper holding part (40) are held together in a force-fitting manner during conveying of a thin flat substrate.

## Revendications

1. Moyen de retenue pour un dispositif de transport (11) pour le transport de substrats minces plats, en particulier de plaquettes de circuits (30 ; 130 ; 230 ; 330), à travers un bain de traitement (12), les moyens de retenue étant configurés sous forme d'étriers de retenue (22 ; 122 ; 222 ; 322) pour connecter fixement à un substrat mince plat et pour connecter ou pour coupler mécaniquement deux substrats minces plats se succédant en direction de transport (T) des substrats minces plats l'un à l'autre, et les étriers de retenue (22 ; 122 ; 222 ; 322) faisant saillie sur deux côtés au-delà de la largeur des substrats minces plats transversalement par rapport à la direction de transport (T) et étant configurés pour coopérer avec une unité de transport (14) du dispositif de transport (11) pour transporter les substrats minces plats à travers le bain de traitement (12),
**caractérisé en ce que**
les étriers de retenue (22 ; 122 ; 222 ; 322) sont configurés sous forme d'étriers de retenue en au moins deux parties avec une partie de retenue inférieure (32 ; 132 ; 232 ; 332) et une partie de retenue supérieure (40 ; 140 ; 240 ; 340), les parties de retenue étant configurées pour fixer un substrat mince plat entre ces deux parties.

2. Moyen de retenue selon la revendication 1, **caractérisé en ce que** transversalement à la direction de transport (T) la partie de retenue inférieure (32 ; 132 ; 232 ; 332) et la partie de retenue supérieure (40 ; 140 ; 240 ; 340) présentent une longueur égale ou la partie de retenue inférieure (32 ; 132 ; 232 ; 332) fait saillie quelque peu au-delà de la partie de retenue supérieure (40 ; 140 ; 240 ; 340).

3. Moyen de retenue selon la revendication 1 ou 2, **caractérisé en ce que** les étriers de retenue (22 ; 122) sont configurés pour une liaison par complémentarité de formes ou un engrènement par complémentarité de formes d'au moins une goupille (38 ; 138) dans un trou traversant (31 ; 131) dans un substrat mince plat.

4. Moyen de retenue selon la revendication 3, **caractérisé en ce qu'**au moins une partie de retenue inférieure (32 ; 132) est pourvue de goupilles (38 ; 138) pour s'engrener dans un substrat mince plat, dans lequel de préférence les goupilles (38 ; 138) passent à travers le substrat mince plat et font saillie au-delà de l'autre côté de telle manière qu'elles s'engrènent dans des percées (44 ; 144) correspondantes dans une partie de retenue supérieure (40 ; 140).

5. Moyen de retenue selon l'une quelconque des revendications 1 à 4, **caractérisé en ce que** les étriers de retenue (22 ; 122) sont configurés pour une liaison par complémentarité de forces entre la partie de retenue inférieure et la partie de retenue supérieure (32, 40 ; 132, 140) par des moyens de force sans contact, de préférence par force magnétique ou sous vide.

6. Moyen de retenue selon l'une quelconque des revendications précédentes, **caractérisé en ce que** les étriers de retenue (22 ; 122 ; 222 ; 322) sont configurés pour une liaison de même type, dans lequel la partie de retenue inférieure (32 ; 132 ; 232 ; 332) est configurée pour placer deux substrats minces plats sur chacun des côtés longitudinaux opposés de la partie de retenue inférieure (32 ; 132 ; 232 ; 332).

7. Moyen de retenue selon la revendication 1 ou 2, **caractérisé en ce qu'**au moins une partie de retenue supérieure (240 ; 340) est montée de manière mobile ou pivotante sur une partie de retenue inférieure (232 ; 332) entre une position ouverte et une position de retenue, dans lequel de préférence dans la position de retenue l'au moins une partie de retenue supérieure (240 ; 340) est appuyée contre la partie de retenue inférieure (232 ; 332) et l'au moins une partie de retenue supérieure (240 ; 340) dans la position de retenue est verrouillée sur la partie de retenue inférieure (232 ; 332).

8. Moyen de retenue selon la revendication 7, **caractérisé en ce que** l'au moins une partie de retenue supérieure (340) est verrouillée dans la position de retenue par verrouillage automatique, en particulier en insérant l'au moins une partie de retenue supérieure (340) par une section de serrage (349), en pente vers la direction d'insertion, sous une saillie de serrage (350) correspondante à la partie de retenue inférieure (332), dans lequel lors de l'insertion avançant de l'au moins une partie de retenue supérieure (340) un pressage contre la partie de retenue inférieure (332) ou contre une section intermédiaire d'un substrat mince plat augmente.

9. Moyen de retenue selon la revendication 6, **caractérisé en ce que** les étriers de retenue (22 ; 122) sont scellés par rapport aux substrats minces plats fixés à ceux-ci par des lèvres en caoutchouc inférieure et supérieure (36, 42 ; 136, 142) arrangées sur les parties de retenue inférieure et supérieure (32 ; 40 ; 132 ; 140), dans lequel la partie de retenue inférieure et la partie de retenue supérieure (32 ; 40 ; 132 ; 140) sont scellées largement contre un substrat mince plat.

10. Moyen de retenue selon l'une quelconque des revendications précédentes, **caractérisé en ce que** les étriers de retenue (22 ; 122 ; 222 ; 322), par des extrémités (25 ; 225 ; 325) faisant saillie latéralement au-delà de l'extension des substrats minces plats transversalement par rapport à la direction de transport (T), peuvent être saisis pour transporter les substrats minces plats, dans lequel de préférence les extrémités (25 ; 225 ; 325) des étriers de retenue (22 ; 122 ; 222 ; 322) sont coudées et des parties de goupilles (226) prévues sur ceux-ci sont arrangées quelque peu au-dessus d'un plan de transport des substrats minces plats.

11. Dispositif de transport (11) avec des moyens de retenue selon l'une quelconque des revendications précédentes, **caractérisé en ce que** le dispositif de transport (11) pour les substrats minces plats et/ou les étriers de retenue (22 ; 122 ; 222 ; 322) présentent chacun à gauche et à droite d'un chemin de transport pour les substrats minces plats une unité de transport (14) avec une courroie tournante respective courant partiellement dans la direction de transport (T) des substrats minces plats ou une chaîne de transport (16) correspondante avec des trous (18) pour fixer les étriers de retenue (22 ; 122 ; 222 ; 322) à celle-ci.

12. Procédé pour le transport de substrats minces plats dans une direction de transport (T) avec un dispositif de transport (11) selon la revendication 11, dans lequel sur les unités de transport (14) du dispositif de transport (11) au moins un premier moyen de retenue et un deuxième moyen de retenue sont prévus à une distance l'un de l'autre dans la direction de transport (T) des substrats minces plats de telle manière qu'un premier substrat mince plat, lors de la mise sur le premier et le deuxième moyen de retenue, reste par des zones d'extrémité sur le premier et le deuxième moyen de retenue ou sur une première partie de retenue inférieure (32a) du premier moyen de retenue et une deuxième partie de retenue inférieure (32b) du deuxième moyen de retenue, ensuite sur la deuxième partie de retenue inférieure (32b) du deuxième moyen de retenue et une autre troisième partie de retenue inférieure (32c) d'un troisième moyen de retenue est placé un deuxième substrat mince plat par zones d'extrémité, et ensuite sur les zones d'extrémité du premier substrat mince plat et les zones d'extrémité du deuxième substrat mince plat une première partie de retenue supérieure (40a) du premier moyen de retenue ou une deuxième partie de retenue supérieure (40b) du deuxième moyen de retenue sont placées sur la première partie de retenue inférieure (32a) du premier moyen de retenue ou la deuxième partie de retenue inférieure (32b) du deuxième moyen de retenue et une rétention mécanique du premier substrat mince plat et du deuxième substrat mince plat se produit sur les premier à troisième moyens de retenue pour empêcher une séparation automatique du premier substrat mince plat et du deuxième substrat mince plat des premier à troisième moyens de retenue, et dans lequel ensuite un mouvement du premier substrat mince plat et du deuxième substrat mince plat sur les premier à troisième moyens de retenue du dispositif de transport (11) dans la direction de transport (T) du premier substrat mince plat et du deuxième substrat mince plat se produit pour transporter le premier substrat mince plat et le deuxième substrat mince plat.

13. Procédé selon la revendication 12, **caractérisé en ce que** les parties de retenue inférieure et supérieure (32, 40) sont retenues ensemble pendant le transport d'un substrat mince plat.

14. Procédé selon la revendication 12 ou 13, **caractérisé en ce que** la partie de retenue inférieure (32) et la partie de retenue supérieure (40) sont retenues ensemble par complémentarité de forces pendant le transport d'un substrat mince plat.
